(19) Europäisches Patentamt
European Patent Office
Office européen des brevets

(11) EP 4 314 849 B1

(12) FASCICULE DE BREVET EUROPEEN

(45) Date de publication et mention de la délivrance du brevet:
**27.11.2024 Bulletin 2024/48**

(21) Numéro de dépôt: **22718665.7**

(22) Date de dépôt: **28.03.2022**

(51) Classification Internationale des Brevets (IPC):
***G01R 31/3842** (2019.01)* ***G01R 35/00** (2006.01)*

(52) Classification Coopérative des Brevets (CPC):
**G01R 31/3842;** G01R 35/005; Y02E 60/10

(86) Numéro de dépôt international:
**PCT/EP2022/058057**

(87) Numéro de publication internationale:
**WO 2022/207531 (06.10.2022 Gazette 2022/40)**

# (54) PROCÉDÉ DE CORRECTION DE LA VARIATION DE TENSION EN CIRCUIT OUVERT LIÉE AU VIEILLISSEMENT D'AU MOINS UN ÉLÉMENT ÉLECTROCHIMIQUE D'UNE BATTERIE ET DISPOSITIFS ASSOCIÉS

VERFAHREN ZUR KORREKTUR DER ÄNDERUNG DER LEERLAUFSPANNUNG DURCH ALTERUNG VON MINDESTENS EINEM ELEKTROCHEMISCHEN ELEMENT EINER BATTERIE UND ZUGEHÖRIGE VORRICHTUNGEN

METHOD FOR CORRECTING THE VARIATION IN OPEN-CIRCUIT VOLTAGE DUE TO AGING OF AT LEAST ONE ELECTROCHEMICAL ELEMENT OF A BATTERY, AND ASSOCIATED DEVICES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.03.2021 FR 2103182**

(43) Date de publication de la demande:
**07.02.2024 Bulletin 2024/06**

(73) Titulaire: **SAFT**
**92300 Levallois-Perret (FR)**

(72) Inventeur: **LAURENT, Sébastien**
**33700 MERIGNAC (FR)**

(74) Mandataire: **Lavoix**
**2, place d'Estienne d'Orves**
**75441 Paris Cedex 09 (FR)**

(56) Documents cités:
**US-A1- 2012 035 873** **US-A1- 2019 064 283**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 4 314 849 B1

## Description

La présente invention concerne un procédé de correction de la variation de tension en circuit ouvert liée au vieillissement d'au moins un élément électrochimique d'une batterie, permettant d'estimer de manière précise l'état de charge dudit élément électrochimique. La présente invention se rapporte aussi à un calculateur, un système de gestion et une batterie associés.

Typiquement une batterie comprend un ou plusieurs accumulateurs de courant appelés aussi générateurs électrochimiques, cellules ou éléments. Un accumulateur est un dispositif de production d'électricité dans lequel de l'énergie chimique est convertie en énergie électrique. L'énergie chimique provient des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Afin d'augmenter la puissance électrique délivrée, on peut associer plusieurs accumulateurs étanches entre eux pour former une batterie. Ainsi, une batterie peut être divisée en modules, chaque module étant composé d'un ou plusieurs accumulateurs reliés entre eux en série et/ou en parallèle. Ainsi, une batterie peut par exemple comporter une ou plusieurs branches parallèles d'accumulateurs reliés en série et/ou une ou plusieurs branches parallèles de modules reliés en série.

Un circuit de charge est généralement prévu auquel la batterie peut être branchée pour recharger les accumulateurs.

Par ailleurs, un système de gestion électronique comprenant des capteurs de mesures et un circuit électronique de contrôle, plus ou moins évolué selon les applications, peut être associé à la batterie. Un tel système permet notamment d'organiser et de contrôler la charge et la décharge de la batterie, pour équilibrer la charge et la décharge des différents accumulateurs de la batterie les uns par rapport aux autres.

L'état de charge est une information utile au système électronique de gestion de la batterie pour optimiser son utilisation et sa durée de vie. L'état de charge est souvent désigné par l'abréviation SOC qui renvoie à la dénomination anglaise de « State of Charge ».

Pour obtenir l'état de charge SOC, il est connu d'utiliser deux techniques de calculs utilisant des mesures continues de l'évolution de la tension, du courant et de la température.

La première technique peut être qualifiée de « coulométrique » dans la mesure où il est utilisé le fait que l'état de charge SOC dépend de la charge (comptage des Ampèresheures) et de la capacité C de la batterie.

En effet, il vient les formules suivantes :

$$SOC = \frac{Ah}{C} = \frac{\sum_i I_i * pas}{C}$$

Où : *pas* est le pas temporel entre deux mesures de courant I.

Toutefois, cette première technique est très sensible à l'erreur de mesure en courant ainsi qu'à l'estimation de la capacité. De ce fait, l'utilisation seule de cette technique conduit à des variations en tension et une estimation erronée de l'état de charge.

La deuxième technique est basée sur les mesures de la tension en circuit ouvert OCV et utilise une table de correspondance préétablie pour obtenir l'état de charge SOC en fonction de la tension en circuit ouvert. La tension en circuit ouvert est souvent désignée par l'abréviation OCV qui renvoie à la dénomination anglaise de « Open Circuit Voltage ».

Comme la fonction qui lie la tension en circuit ouvert OCV à l'état de charge SOC est une fonction de la tension à laquelle est soustraite le produit de la résistance par le courant, la deuxième technique est une technique sensible à l'estimation de la résistance. Aussi, il convient d'utiliser la deuxième technique dans des conditions permettant de minimiser l'erreur sur la résistance, à savoir des conditions de repos ou de courant faible.

Il est connu d'utiliser les deux techniques précitées en utilisant la première technique comme technique habituelle et en recalibrant de manière régulière la tension à l'aide de la deuxième technique.

Toutefois, cette combinaison des deux techniques ne prend pas en compte le vieillissement et notamment les variations de la fonction qui lie la tension en circuit ouvert OCV à l'état de charge SOC en fonction du temps.

En outre, dans certains éléments électrochimiques, du fait que la variation de la tension en circuit ouvert présente un plateau, la correspondance entre la tension en circuit ouvert OCV et l'état de charge SOC peut être fausse.

Il en résulte une variation additionnelle de l'évaluation de l'état de charge SOC. US 2019/064283 A1 et US 2012/035873 A1 divulguent des approches diverses pour déterminer l'état de santé d'une batterie.

Il existe donc un besoin pour un procédé de correction qui permette de prendre en compte la variation de

tension en circuit ouvert liée au vieillissement d'un élément électrochimique d'une batterie, notamment pour améliorer l'estimation de l'état de charge SOC de l'élément électrochimique.

A cet effet, la description décrit un procédé de correction de la variation de tension en circuit ouvert liée au vieillissement d'au moins un élément électrochimique d'une batterie, l'au moins un élément électrochimique présentant une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane comprenant au moins un point de référence, chaque point de référence présentant un état de charge de référence et une tension en circuit ouvert de référence. Le procédé est mis en oeuvre par un calculateur, le calculateur mémorisant une fonction de calibration donnant à partir d'une valeur de tension en circuit ouvert de l'au moins un élément électrochimique la valeur de l'état de charge de l'au moins un élément électrochimique. Le procédé comprend les étapes d'obtention de mesures de la tension et du courant de l'au moins un élément électrochimique lors d'une charge ou d'une décharge comprenant la portion plane et de calcul d'un paramètre de surtension par résolution d'une équation obtenue en calculant la valeur de l'état de charge selon une première technique d'estimation de l'état de charge et une deuxième technique d'estimation de l'état de charge, seule la première technique d'estimation impliquant l'application de la fonction de calibration mémorisée par le calculateur, la surtension de l'au moins un élément électrochimique étant la différence entre la tension de l'au moins un élément électrochimique et la tension en circuit ouvert de l'au moins un élément électrochimique. Le procédé comporte également les étapes de détermination de la valeur mesurée de la tension en circuit ouvert de référence de l'au moins un élément électrochimique pour chaque point de référence en utilisant le paramètre de surtension calculé, et d'estimation de la variation de tension en circuit ouvert liée au vieillissement par comparaison pour chaque point de référence entre la valeur de la tension en circuit ouvert de référence et la valeur mesurée de la tension en circuit ouvert de référence.

Selon des modes de réalisation particuliers, le procédé de correction présente une ou plusieurs des caractéristiques suivantes, prise(s) isolément ou selon toutes les combinaisons techniquement possibles :

- la deuxième technique est une technique d'intégration temporelle des valeurs de courant de l'au moins un élément électrochimique obtenues à l'étape d'obtention.
- la résolution de l'équation est mise en oeuvre par minimisation de l'écart entre les valeurs d'état de charge obtenues par les deux techniques.
- l'état de charge de référence est compris entre 20% et 80%.
- l'état de charge de référence est compris entre 40% et 60%.
- la variation avec le vieillissement de l'état de charge de référence et de la tension en circuit ouvert de référence est inférieure ou égale à 1%.
- l'au moins un élément électrochimique est un élément électrochimique de type $LiFePO_4$, $LiMnFePO_4$ ou LVPF.
- l'au moins un élément électrochimique présente une résistance, le paramètre de surtension étant la valeur de la surtension ou la valeur de la résistance de l'au moins un élément électrochimique.
- lors de l'étape d'obtention, des mesures de température sont également obtenues, la première technique prenant en compte les mesures de température.
- le procédé comprend une étape d'actualisation de la fonction de calibration en fonction de la variation de tension en circuit ouvert liée au vieillissement obtenue à l'étape d'estimation.
- le procédé comprend une étape de calcul de la tension en circuit ouvert corrigée de l'erreur résiduelle de variation de tension en circuit ouvert liée au vieillissement obtenue à l'étape d'estimation.

La description décrit aussi un procédé d'estimation de l'état de charge d'au moins un élément électrochimique d'une batterie, l'au moins un élément électrochimique présentant une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane comprenant au moins un point de référence, chaque point de référence présentant un état de charge de référence et une tension en circuit ouvert de référence, le procédé d'estimation comprenant la mesure de la tension en circuit ouvert de l'au moins un élément électrochimique et la détermination de l'état de charge par application de la fonction de calibration actualisée obtenue après l'étape d'actualisation d'un procédé de correction de la variation de tension en circuit ouvert liée au vieillissement tel que précédemment décrit.

La description propose également un calculateur propre à corriger la variation de tension en circuit ouvert liée au vieillissement d'au moins un élément électrochimique d'une batterie, l'au moins un élément électrochimique présentant une caractéristique état de charge - tension en circuit ouvert avec une portion plane, une portion plane étant une portion dans laquelle la variation de tension en circuit ouvert est inférieure à 30 mV pour une variation d'au moins 1 0% de l'état de charge, la portion plane comprenant au moins un point de référence, chaque point de référence présentant un état de charge de référence et une tension en circuit ouvert de référence, le calculateur mémorisant une fonction de calibration donnant à partir d'une valeur de tension en circuit ouvert de l'au moins un élément électrochimique la valeur de l'état

de charge de l'au moins un élément électrochimique. Le calculateur est propre à obtenir des mesures de la tension et du courant de l'au moins un élément électrochimique lors d'une charge ou d'une décharge comprenant la portion plane et propre à calculer un paramètre de surtension par résolution d'une équation obtenue en calculant la valeur de l'état de charge selon une première technique d'estimation de l'état de charge et une deuxième technique d'estimation de l'état de charge, seule la première technique d'estimation impliquant l'application de la fonction de calibration mémorisée par le calculateur, la surtension de l'au moins un élément électrochimique étant la différence entre la tension de l'au moins un élément électrochimique et la tension en circuit ouvert de l'au moins un élément électrochimique. Le calculateur étant également propre à déterminer la valeur mesurée de la tension en circuit ouvert de référence de l'au moins un élément électrochimique pour chaque point de référence en utilisant le paramètre de surtension calculé, et à estimer la variation de tension en circuit ouvert liée au vieillissement par comparaison pour chaque point de référence entre la valeur de la tension en circuit ouvert de référence et la valeur mesurée de la tension en circuit ouvert de référence.

La description décrit aussi un système de gestion d'au moins un élément électrochimique d'une batterie, l'au moins un élément électrochimique présentant des bornes et une caractéristique état de charge - tension en circuit ouvert avec une portion plane, une portion plane étant une portion dans laquelle la variation de tension en circuit ouvert est inférieure à 30 mV pour une variation d'au moins 10% de l'état de charge, la portion plane comprenant au moins un point de référence, chaque point de référence présentant un état de charge de référence et une tension en circuit ouvert de référence. Le système de gestion comprend un capteur de tension propre à mesurer la tension aux bornes dudit au moins un élément électrochimique lors d'une charge ou d'une décharge comprenant la portion plane, un capteur du courant aux bornes dudit au moins un élément électrochimique lors d'une charge ou d'une décharge comprenant la portion plane, et un calculateur tel que précédemment décrit.

La description propose également une batterie comprenant au moins un élément électrochimique, l'au moins un élément électrochimique présentant des bornes et une caractéristique état de charge -tension en circuit ouvert avec une portion plane, une portion plane étant une portion dans laquelle la variation de tension en circuit ouvert est inférieure à 30 mV pour une variation d'au moins 1 0% de l'état de charge, la portion plane comprenant au moins un point de référence, chaque point de référence présentant un état de charge de référence et une tension en circuit ouvert de référence et la batterie comprenant un système de gestion tel que précédemment décrit.

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un exemple de batterie comportant un élément électrochimique de type $LiFePO_4$,
- la figure 2 est un graphe illustrant des exemples de caractéristiques état de charge
- tension en circuit ouvert de l'élément électrochimique de la figure 1, chaque caractéristique correspondant à un vieillissement distinct, et
- la figure 3 est un ordinogramme d'un exemple de mise en oeuvre de procédé de correction de la variation en tension liée au vieillissement de l'élément électrochimique.

Une batterie 10 est représentée sur la figure 1.

De manière connu en soi, une batterie est généralement un agencement d'une pluralité d'éléments électrochimique mais dans un souci de simplification du propos, il est décrit un cas à un seul élément électrochimique dans ce qui suit, sachant que la transposition à d'autres agencements est immédiate.

La batterie 10 comporte un élément électrochimique 12 et un système de gestion 14 de l'élément électrochimique 12.

Comme expliqué précédemment, un élément électrochimique 12 est un dispositif de production d'électricité dans lequel de l'énergie chimique est convertie en énergie électrique.

L'élément électrochimique 12 délivre donc un courant et une tension entre deux bornes.

L'élément électrochimique 12 présente une caractéristique état de charge SOC - tension en circuit ouvert OCV telle que visible sur la figure 2 en trait noir (le cas illustré est celui de la charge). Cette caractéristique est notée caractéristique SOC/OCV dans la suite.

Dans la figure 2, l'état de charge SOC est exprimé en pourcentage d'un état de charge maximale.

La caractéristique SOC/OCV présente quatre zones, une première zone Z1, une deuxième zone Z2, une troisième zone Z3 et une quatrième zone Z4.

La première zone Z1 correspond au début de la charge et la quatrième zone Z4 à la fin de la charge.

Pour les deux zones intermédiaires, dans la mesure où les deuxième zone Z2 et troisième zone Z3 correspondent à une portion plane, il sera utilisé la dénomination portion plane Z23 dans la suite.

La portion plane Z23 est une portion dans laquelle la variation de tension en circuit ouvert OCV est inférieure à 30 mV (millivolt) pour une variation d'au moins 10% de l'état de charge SOC.

La portion plane Z23 comprend un point de référence présentant un état de charge de référence $SOC_{REF}$ et

une tension en circuit ouvert de référence $OCV_{REF}$.

Dans l'exemple décrit, l'état de charge de référence $SOC_{REF}$ est compris entre 20% et 80%, de préférence entre 30% et 70% et encore préférentiellement entre 40% et 60%.

En outre, la variation avec le vieillissement de l'état de charge de référence $SOC_{REF}$ et de la tension en circuit ouvert de référence $OCV_{REF}$ est inférieure ou égale à 1%. Une telle propriété se retrouve notamment lorsque l'élément électrochimique 12 est un élément électrochimique de type $LiFePO_4$, $LiMnFePO_4$ ou LVPF.

On entend par élément électrochimique de type $LiFePO_4$ ou $LiMnFePO_4$, un élément électrochimique dont l'électrode positive (cathode) comprend un ou des matériaux électrochimiquement actifs dont l'un au moins est à base d'un phosphate lithié d'au moins un métal de transition, de formule $Li_xFe_{1-y}M_yPO_4$ où M est choisi dans le groupe consistant en B, Mg, Al, Si, Ca, Ti, V, Cr, Mn, Co, Ni, Cu, Zn, Y, Zr, Nb et Mo; et $0,8 \leq x \leq 1,2$ ; $0 \leq y \leq 0,6$.

On entend par élément électrochimique de type LVPF, un élément électrochimique dont l'électrode positive (cathode) comprend un ou des matériaux électrochimiquement actifs dont l'un au moins est à base d'un composé de type $LiVPO_4F$.

Cette propriété apparaît bien sur la figure 2 qui représente plusieurs exemples caractéristiques de l'élément électrochimique obtenues pour des utilisations distinctes (et donc des vieillissements distincts) en traits gris. Le point de référence appartient à chacune des caractéristiques. Le point de référence est donc un point invariant au vieillissement.

Le système de gestion 14 est un système propre à gérer l'élément électrochimique 12.

Le système de gestion 14 comporte un capteur de tension 16, un capteur de courant 18 et un calculateur 20.

Le capteur de tension 16 est propre à mesurer la tension aux bornes de l'élément électrochimique 12.

Le capteur de courant 18 est propre à mesurer le courant aux bornes de l'élément électrochimique 12.

Le calculateur 20 est propre à mettre en oeuvre un procédé de correction de la variation de tension liée au vieillissement de l'élément électrochimique 12.

Le calculateur 20 est un circuit électronique conçu pour manipuler et/ou transformer des données représentées par des quantités électroniques ou physiques dans des registres du calculateur et/ou des mémoires en d'autres données similaires correspondant à des données physiques dans les mémoires de registres ou d'autres types de dispositifs d'affichage, de dispositifs de transmission ou de dispositifs de mémorisation.

En tant qu'exemples spécifiques, le calculateur 20 comprend un processeur monocoeur ou multicoeurs (tel qu'une unité de traitement centrale (CPU), une unité de traitement graphique (GPU), un microcontrôleur et un processeur de signal numérique (DSP)), un circuit logique programmable (comme un circuit intégré spécifique à une application (ASIC), un réseau de portes programmables *in situ* (FPGA), un dispositif logique programmable (PLD) et des réseaux logiques programmables (PLA), une machine à états, une porte logique et des composants matériels discrets.

Le calculateur 20 mémorise également une fonction de calibration donnant à partir d'une valeur de tension en circuit ouvert OCV de l'élément électrochimique 12 la valeur de l'état de charge SOC de l'élément électrochimique 12.

La fonction de calibration est notée f dans ce qui suit.

Selon l'exemple décrit, la fonction de calibration f est donnée sous la forme de deux tables correspondantes, la fonction de calibration f correspondant à une interpolation des valeurs de la table.

Ainsi, le calculateur 20 mémorise une table d'états de charge SOC et une table de tensions en circuit ouvert OCV.

Pour la suite, la table d'états de charge SOC est notée $T_{SOC}$ et la table de tensions en circuit ouvert OCV est notée $T_{OCV}$. On note également M la taille de chacune des tables $T_{SOC}$ et $T_{OCV}$.

On comprend bien que dans cette notation, en notant i un entier variant entre 0 et M-1, l'élément i de la table de tension en circuit ouvert OCV $T_{OCV}[i]$ correspond à l'élément i de la table d'états de charge SOC noté $T_{SOC}[i]$. Autrement formulé, l'image par la fonction de calibration de $T_{OCV}[i]$ est $T_{SOC}[i]$, c'est-à-dire $f(T_{OCV}[i]) = T_{SOC}[i]$.

Un exemple de mise en oeuvre du procédé de correction est maintenant décrit en référence à l'ordinogramme de la figure 3.

Le procédé de correction comporte une étape d'obtention E50, une étape de calcul E52, une étape de détermination E54, une étape d'estimation E56 et une étape de correction E58.

Lors de l'étape d'obtention E50, le calculateur 20 obtient des mesures de la tension V et du courant I lors d'une charge comprenant la portion plane Z23.

Dans l'exemple de la figure 3, la charge est une charge complète pour pouvoir corriger la variation de tension liée au vieillissement sur l'ensemble des valeurs possibles de tension en circuit ouvert OCV et d'état de charge SOC.

Selon l'exemple proposé, le calculateur 20 reçoit les mesures de la tension V et du courant I respectivement en provenance du capteur de tension 16 et du capteur de courant 18.

La fréquence des mesures est telle que le nombre de mesures N est supérieur ou égal au nombre de valeurs de la table d'états de charge SOC $T_{SOC}$ et la table de tensions en circuit ouvert OCV $T_{OCV}$, c'est-à-dire supérieur ou égal à M.

En outre, selon l'exemple décrit, le temps écoulé entre deux mesures consécutives, notés $\Delta_T$, est le même entre chaque mesure consécutive.

Le calculateur 20 enregistre les mesures reçues sous forme d'une table de tension notée $T_V$ et d'une table de

courant notée $T_I$.

Chaque élément des tables est noté $T_V[k]$ ou $T_I[k]$

Lors de l'étape de calcul, le paramètre de surtension S est obtenu par le calculateur 20.

La surtension S est définie comme étant la différence entre la tension V de l'élément électrochimique 12 et la tension en circuit ouvert OCV. La surtension S est parfois également dénommée selon son appellation anglaise correspondante de « *overvoltage* ».

Ainsi, la surtension S s'écrit mathématiquement comme :

$$S = V - OCV$$

Dans le mode de réalisation proposé, le paramètre de surtension S calculé est la surtension S elle-même.

Pour cela, le calculateur 20 résout une équation obtenue en calculant la valeur de l'état de charge SOC selon deux techniques d'estimation de l'état de charge SOC.

La première technique T1 utilise la fonction de calibration f mémorisée dans le calculateur 20 et plus spécifiquement la relation suivante :

$$\text{SOC} = f(OCV) = f(V - S)$$

En introduisant une notation tabulaire, cette dernière égalité peut être écrite ainsi :

$$\Delta_{SOC_T1}[k] = \mathrm{T}_{SOC}[k] - \mathrm{T}_{SOC}[0] = f(\mathrm{T}_V[k] - S)$$

La deuxième technique T2 est une technique d'intégration temporelle des valeurs de courant de l'élément électrochimique 12 obtenues à l'étape d'obtention.

Par exemple, pour mettre en oeuvre la deuxième technique T2, il est calculé la charge cumulée (exprimée en Ampère-heure).

En l'espèce, ce calcul est effectué à partir de la table de courant $T_I$ en prenant en compte le temps écoulé $\Delta_T$ entre deux mesures pour former une table de charge accumulée notée $T_{Ah}$.

Aussi, pour un élément k, la charge accumulée s'obtient selon la formule suivante :

$$Ah[k] = \sum_{i=0}^{k} I_i * \Delta_T$$

Il est ensuite calculé la capacité C de l'élément électrochimique 12 comme un rapport entre la charge cumulée maximale $\Delta_{Ah\ Max}$ et la variation maximale de l'état de charge $\Delta_{SOC\ Max}$.

$$C = \frac{\Delta_{Ah\ Max}}{\Delta_{SOC\ Max}}$$

Dans la formule précédente, par définition, la charge cumulée maximale $\Delta_{Ah\ Max}$ est la valeur maximale de charge cumulée et s'écrit comme :

$$\Delta_{Ah\ Max} = \mathrm{T}_{Ah}[N-1] - \mathrm{T}_{Ah}[0]$$

Similairement, la variation maximale de l'état de charge $\Delta_{SOC\ Max}$ s'obtient selon la formule suivante :

$$\Delta_{SOC\ Max} = \mathrm{T}_{SOC}[N-1] - \mathrm{T}_{SOC}[0]$$

Puis, il est calculé la valeur d'état de charge SOC à un instant comme le rapport entre la charge cumulée au même instant et la charge C de l'élément électrochimique 12. Ainsi, il vient pour tout élément k :

$$SOC_{T2}[k] = \frac{\mathrm{T}_{Ah}[k]}{C}$$

La valeur d'état de charge SOC déterminée selon la deuxième technique T2 est considérée comme une valeur fiable.

En traduisant cette égalité pour obtenir un $A_{SOC_T2}[k]$, il suffit de prendre en compte la référence correspondant à l'indice k=0 comme suit :

$$\Delta_{SOC_T2}[k] = SOC_{T2}[k] - SOC_{T2}[0] = \frac{\mathrm{T}_{Ah}[k] - \mathrm{T}_{Ah}[0]}{C} = \frac{\Delta_{Ah}[k]}{\mathrm{C}}$$

En utilisant le fait que les deux techniques T1 et T2 doivent conduire au même résultat, il est obtenu une équation à résoudre qui peut s'écrire :

$$f(\mathrm{T}_V[k] - S) = \Delta_{SOC\ Max} * \frac{\Delta_{Ah}[k]}{\Delta_{Ah\ Max}}$$

Dans cette équation, seule la surtension est inconnue.

Pour résoudre une telle équation, on peut chercher à minimiser l'erreur $\varepsilon[k]$ pour chaque indice k, c'est-à-dire l'écart entre les deux estimations de la valeur de l'état de charge SOC. Pour chaque indice k, l'erreur $\varepsilon[k]$ s'exprime donc ainsi :

$$\varepsilon[k] = \Delta_{SOC}[k] - \Delta_{SOC\ Max} * \frac{\Delta_{Ah}[k]}{\Delta_{Ah\ Max}}$$

Dans le cas décrit, la charge est une charge complète, ce qui implique que la charge accumulée initialement est nulle et que l'état de charge SOC initiale est également nulle. Ainsi :

$$\mathrm{T}_{Ah}[0] = 0 \text{ Ah et } \mathrm{T}_{SOC}[0] = 0\%$$

Il en résulte de l'équation précédente que l'erreur $\varepsilon[k]$ peut se simplifier ainsi :

$$\varepsilon[k] = SOC[k] - SOC[N-1] * \frac{\mathrm{T}_{Ah}[k]}{\mathrm{T}_{Ah}[N-1]}$$

Résoudre l'équation consiste donc à minimiser chacune des valeurs d'erreur $\varepsilon[k]$ pour chaque indice k.

La minimisation des erreurs peut se simplifier par la minimisation de l'erreur quadratique $\varepsilon$ suivante :

$$\varepsilon = \frac{\sum_{k=0}^{N-1}\left[(SOC[k] - SOC[0]) - (SOC[N-1] - SOC[0]) * \frac{\mathrm{T}_{Ah}[k] - \mathrm{T}_{Ah}[0]}{\mathrm{T}_{Ah}[N-1] - \mathrm{T}_{Ah}[0]}\right]^2}{SOC[N-1] - SOC[0]}$$

En cherchant la valeur minimale de l'erreur quadratique pour le paramètre de surtension S, il est obtenu une valeur pour le paramètre de surtension S. Cette valeur est le paramètre de surtension S calculé.

Lors de l'étape de détermination, le calculateur 20 détermine la valeur mesurée de la tension en circuit ouvert de référence $OCV_{REF\ MES}$ de l'élément électrochimique 12 pour le point de référence en utilisant le paramètre de surtension S calculé.

L'étape de détermination est, par exemple, mise en oeuvre comme suit.

Le calculateur 20 calcule une table de tension corrigée $T_{V2}$ en utilisant le paramètre de surtension S obtenu précédemment selon la relation suivante pour chaque indice k compris entre 0 et N-1 :

$$T_{V2}[k] = T_V[k] - S$$

A l'aide de cette table de tension corrigée $T_{V2}$, il est obtenu la valeur mesurée de la tension en circuit ouvert de référence $OCV_{REF\ MES}$ de l'élément électrochimique 12 pour le point de référence.

Par exemple, le calculateur 20 détermine l'indice j tel que la valeur de l'état de charge $T_{SOC}[j]$ est le plus proche de l'état de charge de référence $SOC_{REF}$. La valeur correspondante de la table de tension corrigée $T_{V2}$, à savoir $T_{V2}[j]$ est déterminée par le calculateur 20 comme étant la tension en circuit ouvert de référence $OCV_{REF\ MES}$.

Lors de l'étape d'estimation, le calculateur 20 estime l'erreur résiduelle dans le calcul de la variation de tension en circuit ouvert liée au vieillissement. Pour la suite, cette erreur résiduelle de variation de tension est notée $\varepsilon_{vieillissement}$.

Pour cela, le calculateur 20 calcule la différence entre la valeur de la tension en circuit ouvert de référence $OCV_{REF}$ et la valeur mesurée de la tension en circuit ouvert de référence $OCV_{REF\ MES}$.

Le résultat de cette différence est l'erreur résiduelle de variation de tension $\varepsilon_{vieillissement}$.

Lors de l'étape de correction, le calculateur 20 prend en compte l'erreur résiduelle de variation de tension $\varepsilon_{vieillissement}$ pour la corriger sur une grandeur électrique.

Par exemple, l'étape de correction est une étape de calcul de la tension en circuit ouvert OCV corrigée l'erreur résiduelle de variation de tension $\varepsilon_{vieillissement}$.

Plus précisément, le calculateur 20 calcule une table de tension en circuit ouvert corrigée $T_{OCV}$ en utilisant l'erreur résiduelle de variation de tension $\varepsilon_{vieillissement}$ obtenue précédemment selon la relation suivante pour chaque indice k compris entre 0 et N-1 :

$$T_{OCV}[k] = T_{V2}[k] - \Delta_{vieillissement}$$

Alternativement, dans cet exemple donné sous un formalisme de table, cette étape de correction peut être vue comme une étape d'actualisation de la fonction de calibration f en fonction de l'erreur résiduelle de variation de tension en circuit ouvert liée au vieillissement obtenue à l'étape d'estimation.

Dans le cas où la fonction de calibration f serait une fonction numérique, l'erreur résiduelle de variation de tension $\varepsilon_{vieillissement}$ serait insérée directement dans l'expression mathématique de la fonction de calibration f.

Un tel procédé permet donc de recaler la tension en circuit ouvert en tenant compte du vieillissement de l'élément électrochimique 12.

Cela permet d'améliorer la précision de l'estimation de l'état de charge SOC de l'élément électrochimique 12.

Le procédé est ainsi avantageusement utilisé pour estimer l'état de charge SOC de l'élément électrochimique 12 à tout instant en mesurant la tension en circuit ouvert OCV de l'élément électrochimique 12 et en en déduisant à l'aide de la fonction de calibration f actualisée la valeur de l'état de charge SOC.

Il est à noter que ce recalage est effectué lors d'une charge ou d'une décharge à fort courant, c'est-à-dire dans le cadre d'une utilisation normale de la batterie 10.

En particulier, il n'est pas utilisé un profil spécifique impliquant un courant très faible et donc une immobilisation temporaire de l'emploi de la batterie 10.

Du fait de cette simplicité et de la charge de calcul relativement faible pour le calculateur 20, le procédé est compatible avec une mise en oeuvre embarqué.

Le procédé utilise ainsi avantageusement ce qui est considéré comme un défaut de certaines caractéristiques SOC-OCV, à savoir la présence d'une portion plane.

Plus spécifiquement, il est utilisé un point de référence de cette portion plane en utilisant la propriété d'invariance par vieillissement de ses coordonnées dans l'espace SOC-OCV. D'autres modes de réalisation du procédé utilisant la même propriété sont également envisageables.

Notamment, le procédé qui vient d'être décrit est réalisé pendant une charge complète et peut également être mis en oeuvre sur une décharge complète.

De manière générale, le procédé peut être mis en oeuvre pourvu qu'il soit possible de déterminer la valeur mesurée de la tension en circuit ouvert de référence $OCV_{REF\ MES}$ avec suffisamment de précision, ce qui suppose que la charge ou la décharge comprenne la portion plane.

Le procédé décrit permet d'obtenir la surtension S elle-même comme paramètre de surtension.

Dans un mode de réalisation, il est pris en compte le fait que la surtension S dépend du courant et le paramètre de surtension est la résistance R de l'élément électrochimique 12.

Dans ce cas, la première technique T1 est modifiée en utilisant la formule $f(T_V[k] - R * T_I[k])$ au lieu de la formule $f(T_V[k] - S)$.

Selon un autre mode de réalisation, il est également pris en compte la température et la surtension S est alors une fonction du courant et de la température.

Dans une telle configuration, le système de gestion 14 comporte, en outre, un capteur de température qui mesure en temps réel la température de l'élément électrochimique 12.

Le procédé propose un ordre d'étapes spécifiques mais celui-ci peut être différent.

Par exemple, il peut être envisagé d'effectuer la minimisation puis ou simultanément de calculer la table d'état de charge SOC basé sur la charge accumulée.

Les calculs peuvent être faits aussi de manière différente, par exemple par l'emploi d'une deuxième technique d'estimation T2 différente pourvu qu'elle n'implique pas l'emploi de la fonction de calibration f.

Il est également possible de renforcer la précision du procédé en utilisant plusieurs points de référence.

Par exemple, le point de référence pourrait être un unique point dont les coordonnées seraient obtenues en moyennant l'ensemble des coordonnées des points de référence.

Alternativement, lors de l'étape de détermination, il est déterminé la valeur mesurée de la tension en circuit ouvert de référence $OCV_{REF\ MES}$ de l'élément électrochimique 12 pour chaque point de référence.

L'étape d'estimation de l'erreur résiduelle de variation de tension $\varepsilon_{vieillissement}$ est alors effectuée par comparaison pour chaque point de référence entre la valeur de la tension en circuit ouvert de référence $OCV_{REF}$ et la valeur mesurée de la tension en circuit ouvert de référence $OCV_{REF\ MES}$.

De manière simple, il peut être considéré une moyenne arithmétique des différences entre la valeur de la tension en circuit ouvert de référence $OCV_{REF}$ et la valeur mesurée de la tension en circuit ouvert de référence $OCV_{REF\ MES}$ pour chaque point.

Il peut aussi être envisagé des formules plus complexes utilisant chacune des valeurs, à savoir les valeurs de la tension en circuit ouvert de référence $OCV_{REF}$ et les valeurs mesurées de la tension en circuit ouvert de référence $OCV_{REF\ MES}$.

Il a ainsi été décrit un procédé de correction de la variation de tension liée au vieillissement d'un élément électrochimique 12.

Toutefois, un tel procédé est utilisable pour toute assemblage d'éléments électrochimiques 12 et par là avec toute batterie 10 de configuration générale xs*yp.

Le procédé permet donc d'obtenir une mesure d'état de charge SOC fiable pour toute batterie 10 en offrant la possibilité d'effectuer un recalage in situ.

## Revendications

1. Procédé de correction de la variation de tension en circuit ouvert liée au vieillissement d'au moins un élément électrochimique (12) d'une batterie (10), le procédé comprenant une étape d'obtention de mesures de la tension et du courant de l'au moins un élément électrochimique (12) lors d'une charge ou d'une décharge comprenant la portion plane,
le procédé étant **caractérisé**:

   **en ce que** l'au moins un élément électrochimique (12) présentant une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane comprenant au moins un point de référence, chaque point de référence présentant un état de charge de référence ($SOC_{REF}$) et une tension en circuit ouvert de référence ($OCV_{REF}$), le procédé étant mis en oeuvre par un calculateur (20), le calculateur (20) mémorisant une fonction de calibration (f) donnant à partir d'une valeur de tension en circuit ouvert (OCV) de l'au moins un élément électrochimique (12) la valeur de l'état de charge (SOC) de l'au moins un élément électrochimique (12), et
   **en ce que** le procédé comporte les étapes de :

   - calcul d'un paramètre de surtension par résolution d'une équation obtenue en calculant la valeur de l'état de charge (SOC) selon une première technique d'estimation de l'état de charge (SOC) et une deuxième technique d'estimation de l'état de charge (SOC), seule la première technique d'estimation impliquant l'application de la fonction de calibration (f) mémorisée par le calculateur (20), la surtension de l'au moins un élément électrochimique (12) étant la différence entre la tension de l'au moins un élément électrochimique (12) et la tension en circuit ouvert de l'au moins un élément électrochimique (12),
   - détermination de la valeur mesurée de la tension en circuit ouvert de référence ($OCV_{REF\ MES}$) de l'au moins un élément électrochimique (12) pour chaque point de référence en utilisant le paramètre de surtension calculé, et
   - estimation de la variation de tension en circuit ouvert liée au vieillissement par comparaison pour chaque point de référence entre la valeur de la tension en circuit ouvert de référence ($OCV_{REF}$) et la valeur mesurée

de la tension en circuit ouvert de référence ($OCV_{REF\ MES}$).

**2.** Procédé de correction selon la revendication 1, dans lequel la deuxième technique est une technique d'intégration temporelle des valeurs de courant de l'au moins un élément électrochimique (12) obtenues à l'étape d'obtention.

**3.** Procédé de correction selon la revendication 1 ou 2, dans lequel la résolution de l'équation est mise en oeuvre par minimisation de l'écart entre les valeurs d'état de charge (SOC) obtenues par les deux techniques.

**4.** Procédé de correction selon l'une quelconque des revendications 1 à 3, dans lequel chaque point de référence vérifie au moins l'une des propriétés suivantes :

- l'état de charge de référence ($SOC_{REF}$) est compris entre 20% et 80%,
- l'état de charge de référence ($SOC_{REF}$) est compris entre 40% et 60%, et
- la variation avec le vieillissement de l'état de charge de référence ($SOC_{REF}$) et de la tension en circuit ouvert de référence ($OCV_{REF}$) est inférieure ou égale à 1%.

**5.** Procédé de correction selon l'une quelconque des revendications 1 à 4, dans lequel l'au moins un élément électrochimique (12) est un élément électrochimique de type $LiFePO_4$, $LiMnFePO_4$ ou LVPF.

**6.** Procédé de correction selon l'une quelconque des revendications 1 à 5, dans lequel l'au moins un élément électrochimique (12) présente une résistance, le paramètre de surtension étant la valeur de la surtension ou la valeur de la résistance de l'au moins un élément électrochimique (12).

**7.** Procédé de correction selon l'une quelconque des revendications 1 à 6, dans lequel, lors de l'étape d'obtention, des mesures de température sont également obtenues, la première technique prenant en compte les mesures de température.

**8.** Procédé de correction selon l'une quelconque des revendications 1 à 7, dans lequel le procédé comprend une étape d'actualisation de la fonction de calibration en fonction de la variation de tension en circuit ouvert liée au vieillissement obtenue à l'étape d'estimation.

**9.** Procédé de correction selon l'une quelconque des revendications 1 à 8, dans lequel le procédé comprend une étape de calcul de la tension en circuit ouvert (OCV) corrigée de l'erreur résiduelle de variation de tension en circuit ouvert liée au vieillissement obtenue à l'étape d'estimation.

**10.** Procédé d'estimation de l'état de charge (SOC) d'au moins un élément électrochimique (12) d'une batterie (10), l'au moins un élément électrochimique (12) présentant une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane comprenant au moins un point de référence, chaque point de référence présentant un état de charge de référence ($SOC_{REF}$) et une tension en circuit ouvert de référence ($OCV_{REF}$), le procédé d'estimation comprenant la mesure de la tension en circuit ouvert (OCV) de l'au moins un élément électrochimique (12) et la détermination de l'état de charge (SOC) par application de la fonction de calibration actualisée obtenue après l'étape d'actualisation d'un procédé de correction de la variation de tension en circuit ouvert liée au vieillissement selon la revendication 8.

**11.** Calculateur (20) propre à corriger la variation de tension en circuit ouvert liée au vieillissement d'au moins un élément électrochimique (12) d'une batterie (10), le calculateur (20) étant propre à obtenir des mesures de la tension et du courant de l'au moins un élément électrochimique (12) lors d'une charge ou d'une décharge comprenant la portion plane,
le calculateur (20) étant **caractérisé** :

**en ce que** l'au moins un élément électrochimique (12) présentant une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane comprenant au moins un point de référence, chaque point de référence présentant un état de charge de référence ($SOC_{REF}$) et une tension en circuit ouvert de référence ($OCV_{REF}$), le calculateur (20) mémorisant une fonction de calibration (f) donnant à partir d'une valeur de tension en circuit ouvert (OCV) de l'au moins un élément électrochimique (12) la valeur de l'état de charge (SOC) de l'au moins

un élément électrochimique (12), et
**en ce que** le calculateur (20) est propre à :

- calculer un paramètre de surtension par résolution d'une équation obtenue en calculant la valeur de l'état de charge (SOC) selon une première technique d'estimation de l'état de charge (SOC) et une deuxième technique d'estimation de l'état de charge (SOC), seule la première technique d'estimation impliquant l'application de la fonction de calibration mémorisée par le calculateur (20), la surtension de l'au moins un élément électrochimique (12) étant la différence entre la tension de l'au moins un élément électrochimique (12) et la tension en circuit ouvert de l'au moins un élément électrochimique (12),
- déterminer la valeur mesurée de la tension en circuit ouvert de référence ($OCV_{REF\ MES}$) de l'au moins un élément électrochimique (12) pour chaque point de référence en utilisant le paramètre de surtension calculé, et
- estimer la variation de tension en circuit ouvert liée au vieillissement par comparaison pour chaque point de référence entre la valeur de la tension en circuit ouvert de référence ($OCV_{REF}$) et la valeur mesurée de la tension en circuit ouvert de référence ($OCV_{REF\ MES}$).

**12.** Système de gestion (14) d'au moins un élément électrochimique (12) d'une batterie (10), l'au moins un élément électrochimique (12) présentant des bornes et une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane comprenant au moins un point de référence, chaque point de référence présentant un état de charge de référence ($SOC_{REF}$) et une tension en circuit ouvert de référence ($OCV_{REF}$), le système de gestion (14) comprenant :

- un capteur de tension (16) propre à mesurer la tension aux bornes dudit au moins un élément électrochimique (12) lors d'une charge ou d'une décharge comprenant la portion plane,
- un capteur du courant aux bornes dudit au moins un élément électrochimique (12) lors d'une charge ou d'une décharge comprenant la portion plane, et
- un calculateur (20) selon la revendication 11.

**13.** Batterie (10) comprenant :

- au moins un élément électrochimique (12), l'au moins un élément électrochimique (12) présentant des bornes et une caractéristique état de charge (SOC) - tension en circuit ouvert (OCV) avec une portion plane, une portion plane étant une portion dans laquelle la variation de tension en circuit ouvert (OCV) est inférieure à 30 mV pour une variation d'au moins 10% de l'état de charge (SOC), la portion plane comprenant au moins un point de référence, chaque point de référence présentant un état de charge de référence ($SOC_{REF}$) et une tension en circuit ouvert de référence ($OCV_{REF}$), et
- un système de gestion (14) selon la revendication 12.

## Patentansprüche

**1.** Verfahren zur Korrektur der alterungsbedingten Änderung der Leerlaufspannung von mindestens einem elektrochemischen Element (12) einer Batterie (10), wobei das Verfahren einen Schritt zum Erhalten von Messungen der Spannung und des Stroms des mindestens einen elektrochemischen Elements (12) während einer Ladung oder Entladung umfasst, die den ebenen Abschnitt umfasst,
wobei das Verfahren **dadurch gekennzeichnet ist**:

**dass** das mindestens eine elektrochemische Element (12) eine Ladezustands-(SOC)-Leerlaufspannungs-(OCV)-Kennlinie mit einem ebenen Abschnitt aufweist, wobei ein ebener Abschnitt ein Abschnitt ist, in dem die Änderung der Leerlaufspannung (OCV) weniger als 30 mV bei einer Änderung des Ladezustands (SOC) um mindestens 10 % beträgt, wobei der ebene Abschnitt mindestens einen Referenzpunkt umfasst, wobei jeder Referenzpunkt einen Referenz-Ladezustand ($SOC_{REF}$) und eine Referenz-Leerlaufspannung ($OCV_{REF}$) aufweist,
wobei das Verfahren von einem Rechner (20) durchgeführt wird, wobei der Rechner (20) eine Kalibrierungsfunktion (f) speichert, die aus einem Wert der Leerlaufspannung (OCV) des mindestens einen elektrochemischen Elements (12) den Wert des Ladezustands (SOC) des mindestens einen elektrochemischen Elements (12) ermittelt, und

**dass** das Verfahren die folgenden Schritte aufweist:

- Berechnen eines Überspannungsparameters durch Lösen einer Gleichung, die durch Berechnen des Werts des Ladezustands (SOC) gemäß einer ersten Technik zum Schätzen des Ladezustands (SOC) und einer zweiten Technik zum Schätzen des Ladezustands (SOC) erhalten wird, wobei nur die erste Schätztechnik die Anwendung der von dem Rechner (20) gespeicherten Kalibrierungsfunktion (f) beinhaltet, wobei die Überspannung des mindestens einen elektrochemischen Elements (12) die Differenz zwischen der Spannung des mindestens einen elektrochemischen Elements (12) und der Leerlaufspannung des mindestens einen elektrochemischen Elements (12) ist,
- Bestimmen des gemessenen Werts der Referenz-Leerlaufspannung ($OCV_{REF\ MES}$) des mindestens einen elektrochemischen Elements (12) für jeden Referenzpunkt unter Verwendung des berechneten Überspannungsparameters, und
- Schätzen der alterungsbedingten Änderung der Leerlaufspannung durch Vergleich für jeden Referenzpunkt zwischen dem Wert der Referenz-Leerlaufspannung ($OCV_{REF}$) und dem gemessenen Wert der Referenz-Leerlaufspannung ($OCV_{REF\ MES}$).

**2.** Korrekturverfahren nach Anspruch 1, wobei die zweite Technik eine Technik der zeitlichen Integration der Stromwerte des mindestens einen elektrochemischen Elements (12) ist, die in dem Schritt zum Erhalten erhalten wurden.

**3.** Korrekturverfahren nach Anspruch 1 oder 2, wobei die Lösung der Gleichung durch Minimieren der Abweichung zwischen den Werten des Ladezustands (SOC), die durch die beiden Techniken erhalten wurden, durchgeführt wird.

**4.** Korrekturverfahren nach einem der Ansprüche 1 bis 3, wobei jeder Referenzpunkt mindestens eine der folgenden Eigenschaften überprüft:

- der Referenzladezustand ($SOC_{REF}$) liegt zwischen 20 % und 80 %,
- der Referenzladezustand ($SOC_{REF}$) liegt zwischen 40 % und 60 %, und
- die alterungsbedingte Änderung des Referenzladezustands ($SOC_{REF}$) und der Referenzleerlaufspannung ($OCV_{REF}$) ist kleiner oder gleich 1 %.

**5.** Korrekturverfahren nach einem der Ansprüche 1 bis 4, wobei das mindestens eine elektrochemische Element (12) ein elektrochemisches Element vom Typ $LiFePO_4$, $LiMnFePO_4$ oder LVPF ist.

**6.** Korrekturverfahren nach einem der Ansprüche 1 bis 5, wobei das mindestens eine elektrochemische Element (12) einen Widerstand aufweist, wobei der Überspannungsparameter der Wert der Überspannung oder der Wert des Widerstands des mindestens einen elektrochemischen Elements (12) ist.

**7.** Korrekturverfahren nach einem der Ansprüche 1 bis 6, wobei im Schritt zum Erhalten auch Temperaturmessungen erhalten werden, wobei die erste Technik die Temperaturmessungen berücksichtigt.

**8.** Korrekturverfahren nach einem der Ansprüche 1 bis 7, wobei das Verfahren einen Schritt des Aktualisierens der Kalibrierungsfunktion in Abhängigkeit von der im Schätzschritt erhaltenen alterungsbedingten Leerlaufspannungsänderung umfasst.

**9.** Korrekturverfahren nach einem der Ansprüche 1 bis 8, wobei das Verfahren einen Schritt des Berechnens der Leerlaufspannung (OCV) umfasst, die um den im Schätzschritt erhaltenen Restfehler der alterungsbedingten Leerlaufspannungsänderung korrigiert wurde.

**10.** Verfahren zum Schätzen des Ladezustands (SOC) mindestens eines elektrochemischen Elements (12) einer Batterie (10), wobei das mindestens eine elektrochemische Element (12) eine Ladezustands-(SOC)-Leerlaufspannungs-(OCV)-Kennlinie mit einem ebenen Abschnitt aufweist, wobei ein ebener Abschnitt ein Abschnitt ist, in dem die Änderung der Leerlaufspannung (OCV) weniger als 30 mV bei einer Änderung des Ladezustands (SOC) um mindestens 10 % beträgt, wobei der ebene Abschnitt mindestens einen Referenzpunkt umfasst, wobei jeder Referenzpunkt einen Referenz-Ladezustand ($SOC_{REF}$) und eine Referenz-Leerlaufspannung ($OCV_{REF}$) aufweist, wobei das Schätzverfahren das Messen der Leerlaufspannung (OCV) des mindestens einen elektrochemischen Elements (12) und das Bestimmen der Leerlaufspannung (OCV) durch Anwendung der aktualisierten Kalibrierungsfunktion umfasst, die nach dem Aktualisierungsschritt eines Korrekturverfahrens der altersbedingten Änderung der Leerlaufspannung nach Anspruch 8 erhalten wurde.

**11.** Rechner (20), der dazu geeignet ist, die altersbedingte Änderung der Leerlaufspannung mindestens eines elektrochemischen Elements (12) einer Batterie (10) zu korrigieren, wobei der Rechner (20) dazu geeignet ist, Messungen der Spannung und des Stroms des mindestens einen elektrochemischen Elements (12) während einer Ladung oder Entladung, die den ebenen Abschnitt umfasst, zu erhalten,
wobei der Rechner (20) **dadurch gekennzeichnet ist**:

**dass** das mindestens ein elektrochemisches Element (12) eine Ladezustands-(SOC)-Leerlaufspannungs-(OCV)-Kennlinie mit einem ebenen Abschnitt aufweist, wobei ein ebener Abschnitt ein Abschnitt ist, in dem die Änderung der Leerlaufspannung (OCV) weniger als 30 mV bei einer Änderung des Ladezustands (SOC) um mindestens 10 % beträgt, wobei der ebene Abschnitt mindestens einen Referenzpunkt umfasst, wobei jeder Referenzpunkt einen Referenz-Ladezustand ($SOC_{REF}$) und eine Referenz-Leerlaufspannung ($OCV_{REF}$) aufweist,
wobei der Rechner (20) eine Kalibrierungsfunktion (f) speichert,
die aus einem
Wert der Leerlaufspannung (OCV) des mindestens einen elektrochemischen Elements (12) den Wert des Ladezustands (SOC) des mindestens einen elektrochemischen Elements (12) ermittelt, und dass der Rechner (20) geeignet ist:

- einen Überspannungsparameter durch Lösen einer Gleichung, die durch Berechnen des Werts des Ladezustands (SOC) gemäß einer ersten Technik zum Schätzen des Ladezustands (SOC) und einer zweiten Technik zum Schätzen des Ladezustands (SOC) erhalten wird, zu berechnen, wobei nur die erste Schätztechnik die Anwendung der vom Rechner (20) gespeicherten Kalibrierungsfunktion beinhaltet, wobei die Überspannung des mindestens einen elektrochemischen Elements (12) die Differenz zwischen der Spannung des mindestens einen elektrochemischen Elements (12) und der Leerlaufspannung des mindestens einen elektrochemischen Elements (12) ist,
- den gemessenen Wert der Referenz-Leerlaufspannung ($OCV_{REF\ MES}$) des mindestens einen elektrochemischen Elements (12) für jeden Referenzpunkt unter Verwendung des berechneten Überspannungsparameters zu bestimmen, und
- die alterungsbedingte Änderung der Leerlaufspannung durch Vergleich für jeden Referenzpunkt zwischen dem Wert der Referenz-Leerlaufspannung ($OCV_{REF}$) und dem gemessenen Wert der Referenz-Leerlaufspannung ($OCV_{REF\ MES}$) zu SCHÄTZEN.

**12.** System zur Verwaltung (14) von mindestens einem elektrochemischen Element (12) einer Batterie (10), wobei das mindestens eine elektrochemische Element (12) Klemmen und eine Ladezustands-(SOC)-Leerlaufspannungs-(OCV)-Kennlinie mit einem ebenen Abschnitt aufweist, wobei ein ebener Abschnitt ein Abschnitt ist, in dem die Änderung der Leerlaufspannung (OCV) weniger als 30 mV bei einer Änderung des Ladezustands (SOC) um mindestens 10 % beträgt, wobei der ebene Abschnitt mindestens einen Referenzpunkt umfasst, wobei jeder Referenzpunkt einen Referenz-Ladezustand ($SOC_{REF}$) UND EINE REFERENZ-LEERLAUFSPANNUNG ($OCV_{REF}$) aufweist, wobei das Verwaltungssystem (14) umfasst:

- einen Spannungssensor (16), der imstande ist, die Spannung an den Klemmen des mindestens einen elektrochemischen Elements (12) während einer Ladung oder Entladung, die den ebenen Abschnitt umfasst, zu messen,
- einen Stromsensor an den Klemmen des mindestens einen elektrochemischen Elements (12) während einer Ladung oder Entladung, die den ebenen Abschnitt umfasst, und
- einen Rechner (20) nach Anspruch 11.

**13.** Batterie (10), umfassend:

- mindestens ein elektrochemisches Element (12), wobei das mindestens eine elektrochemische Element (12) Klemmen und eine Ladezustands-(SOC)-Leerlaufspannungs-(OCV)-Kennlinie mit einem ebenen Abschnitt aufweist, wobei ein ebener Abschnitt ein Abschnitt ist, in dem die Änderung der Leerlaufspannung (OCV) weniger als 30 mV bei einer Änderung des Ladezustands (SOC) um mindestens 10 % beträgt, wobei der ebene Abschnitt mindestens einen Referenzpunkt umfasst, wobei jeder Referenzpunkt einen Referenz-Ladezustand ($SOC_{REF}$) und eine Referenz-Leerlaufspannung ($OCV_{REF}$) aufweist, und
- ein Verwaltungssystem (14) nach Anspruch 12.

## Claims

1. A method for correcting the variation in open-circuit voltage due to ageing of at least one electrochemical cell (12) of a battery (10), the method comprising a step of obtaining measurements of the voltage and current of the at least one electrochemical cell (12) during a charge or discharge comprising the planar portion,
the method being **characterised**:

    **in that** the at least one electrochemical cell (12) has a state of charge (SOC) - open-circuit voltage (OCV) characteristic with a planar portion, a planar portion being a portion wherein the variation in open-circuit voltage (OCV) is less than 30 mV for a variation of at least 10% in the state of charge (SOC), the planar portion comprising at least one reference point, each reference point having a reference state of charge ($SOC_{REF}$) and a reference open-circuit voltage ($OCV_{REF}$), the method being implemented by a computer (20), the computer (20) storing a calibration function (f) which gives, on the basis of an open-circuit voltage value (OCV) of the at least one electrochemical cell (12), the value of the state of charge (SOC) of the at least one electrochemical cell (12), and **characterised in that** the method comprises the steps of:

    - calculating an overvoltage parameter by solving an equation obtained by calculating the value of the state of charge (SOC) according to a first technique for estimating the state of charge (SOC) and a second technique for estimating the state of charge (SOC), wherein only the first estimation technique involves the application of the calibration function (f) stored by the computer (20), the overvoltage of the at least one electrochemical cell (12) being the difference between the voltage of the at least one electrochemical cell (12) and the open-circuit voltage of the at least one electrochemical cell (12),
    - determining the measured value of the reference open-circuit voltage ($OCV_{REF\ MES}$) of the at least one electrochemical cell (12) for each reference point using the calculated overvoltage parameter, and
    - estimating the variation in open-circuit voltage related to ageing by comparing, for each reference point, the value of the reference open-circuit voltage ($OCV_{REF}$) and the measured value of the reference open-circuit voltage ($OCV_{REF\ MES}$).

2. The correction method according to claim 1, wherein the second technique is a time integration technique of the current values of the at least one electrochemical cell (12) obtained in the step of obtaining.

3. The correction method according to claim 1 or 2, wherein the equation is solved by minimising the difference between the state of charge (SOC) values obtained by the two techniques.

4. The correction method according to any one of claims 1 to 3, wherein each reference point satisfies at least one of the following properties:

    - the reference state of charge ($SOC_{REF}$) is between 20% and 80%,
    - the reference state of charge ($SOC_{REF}$) is between 40% and 60%, and
    - the variation with ageing in the reference state of charge ($SOC_{REF}$) and the reference open-circuit voltage ($OCV_{REF}$) is less than or equal to 1%.

5. The correction method according to any one of claims 1 to 4, wherein the at least one electrochemical cell (12) is an electrochemical cell of the $LiFePO_4$, $LiMnFePO_4$ or LVPF type.

6. The correction method according to any one of claims 1 to 5, wherein the at least one electrochemical cell (12) has a resistance, the overvoltage parameter being the value of the overvoltage or the value of the resistance of the at least one electrochemical cell (12).

7. The correction method according to any one of claims 1 to 6, wherein, during the step of obtaining, temperature measurements are also obtained, the first technique taking account of the temperature measurements.

8. The correction method according to any one of claims 1 to 7, wherein the method comprises a step of updating the calibration function as a function of the variation in open-circuit voltage related to ageing obtained in the estimation step.

9. The correction method according to any one of claims 1 to 8, wherein the method comprises a step of calculating the open-circuit voltage (OCV) corrected for the residual error in variation in open-circuit voltage related to ageing

obtained in the estimation step.

**10.** A method for estimating the state of charge (SOC) of at least one electrochemical cell (12) of a battery (10), the at least one electrochemical cell (12) having a state of charge (SOC) - open-circuit voltage (OCV) characteristic with a planar portion, a planar portion being a portion wherein the variation in open-circuit voltage (OCV) is less than 30 mV for a variation of at least 10% in the state of charge (SOC), the planar portion comprising at least one reference point, each reference point having a reference state of charge ($SOC_{REF}$) and a reference open-circuit voltage ($OCV_{REF}$), the estimation method comprising the measurement of the open-circuit voltage (OCV) of the at least one electrochemical cell (12) and the determining of the state of charge (SOC) by applying the updated calibration function obtained after the updating step of a method for correcting the variation in open-circuit voltage due to ageing according to claim 8.

**11.** A computer (20) capable of correcting the variation in open-circuit voltage due to ageing of at least one electrochemical cell (12) of a battery (10), the computer (20) being capable of obtaining measurements of the voltage and current of the at least one electrochemical cell (12) during a charge or discharge comprising the planar portion,
the computer (20) being **characterised**:

**in that** the at least one electrochemical cell (12) has a state of charge (SOC) - open-circuit voltage (OCV) characteristic with a planar portion, a planar portion being a portion wherein the variation in open-circuit voltage (OCV) is less than 30 mV for a variation of at least 10% in the state of charge (SOC), the planar portion comprising at least one reference point, each reference point having a reference state of charge ($SOC_{REF}$) and a reference open-circuit voltage ($OCV_{REF}$), the computer (20) memorising the calibration function (f) which gives, on the basis of an open-circuit voltage value (OCV) of the at least one electrochemical cell (12), the value of the state of charge (SOC) of the at least one electrochemical cell (12), and in that the computer (20) is capable of:

- calculating an overvoltage parameter by solving an equation obtained by calculating the value of the state of charge (SOC) according to a first technique for estimating the state of charge (SOC) and a second technique for estimating the state of charge (SOC), wherein only the first estimation technique involves the application of the calibration function stored by the computer (20), the overvoltage of the at least one electrochemical cell (12) being the difference between the voltage of the at least one electrochemical cell (12) and the open-circuit voltage of the at least one electrochemical cell (12),
- determining the measured value of the reference open-circuit voltage ($OCV_{REF\ MES}$) of the at least one electrochemical cell (12) for each reference point using the calculated overvoltage parameter, and
- estimating the variation in open-circuit voltage related to ageing by comparing, for each reference point, the value of the reference open-circuit voltage ($OCV_{REF}$) and the measured value of the reference open-circuit voltage ($OCV_{REF\ MES}$).

**12.** A system for managing (14) at least one electrochemical cell (12) of a battery (10), the at least one electrochemical cell (12) having terminals and a state of charge (SOC) - open-circuit voltage (OCV) characteristic with a planar portion, a planar portion being a portion wherein the variation in open-circuit voltage (OCV) is less than 30 mV for a variation of at least 10% in the state of charge (SOC), the planar portion comprising at least one reference point, each reference point having a reference state of charge ($SOC_{REF}$) and a reference open-circuit voltage ($OCV_{REF}$), the management system (14) comprising:

- a voltage sensor (16) capable of measuring the voltage across said at least one electrochemical cell (12) during a charge or discharge comprising the planar portion,
- a current sensor at the terminals of said at least one electrochemical cell (12) during a charge or discharge comprising the planar portion, and
- a computer (20) according to claim 11.

**13.** A battery (10) comprising:

- at least one electrochemical cell (12), the at least one electrochemical cell (12) having terminals and a state of charge (SOC) - open-circuit voltage (OCV) characteristic with a planar portion, a planar portion being a portion wherein the variation in open-circuit voltage (OCV) is less than 30 mV for a variation of at least 10% in the state of charge (SOC), the planar portion comprising at least one reference point, each reference point having a reference state of charge ($SOC_{REF}$) and a reference open-circuit voltage ($OCV_{REF}$), and

- a management system (14) according to claim 12.

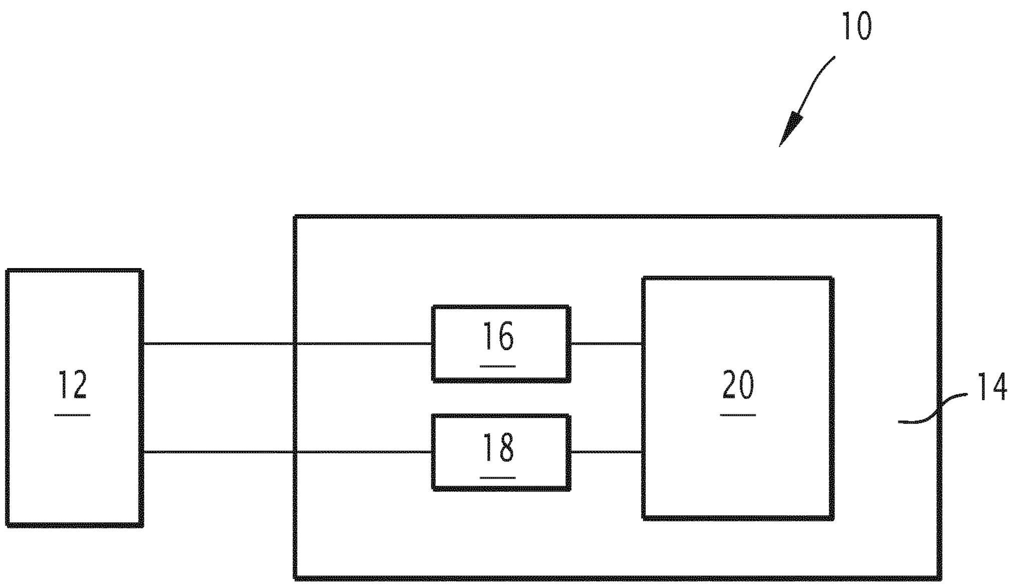


FIG.1

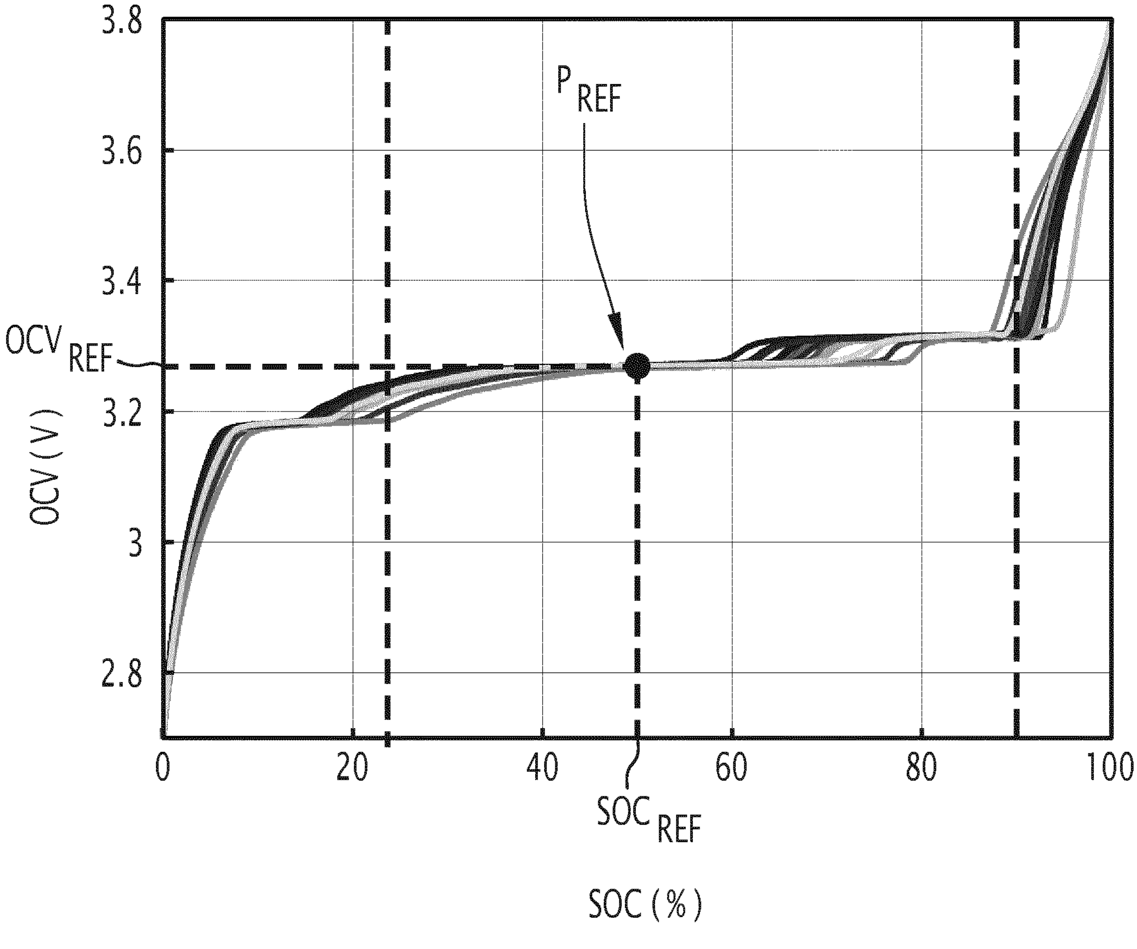


FIG.2

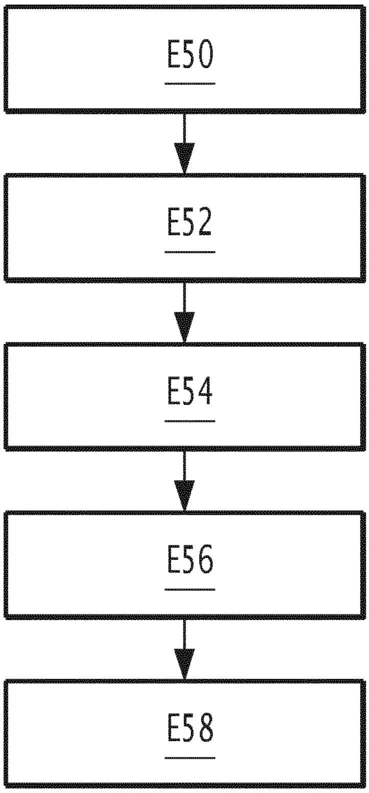


FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2019064283 A1
- US 2012035873 A1